# EUROPEAN PATENT SPECIFICATION

(11) **EP 3 114 910 B1**
(45) Date of publication and mention of the grant of the patent: **28.10.2020**
(21) Application number: 15759000.1
(22) Date of filing: 16.02.2015
(51) Int. Cl.: H05K 1/18, H05K 3/12, H05K 3/28, H05K 1/02, H05K 1/09, H05K 3/00, H05K 3/30

(54) **METHOD FOR MANUFACTURING ELECTRONIC PRODUCTS AND RELATED MANUFACTURING ARRANGEMENT**
VERFAHREN ZUR HERSTELLUNG ELEKTRONISCHER PRODUKTE UND ENTSPRECHENDE HERSTELLUNGSANORDNUNG
PROCÉDÉ DE FABRICATION DE PRODUITS ÉLECTRONIQUES ET AGENCEMENT DE FABRICATION ASSOCIÉ

(30) Priority: 06.03.2014 US 201414198833
(43) Date of publication of application: 11.01.2017
(73) Proprietor: TactoTek Oy, 90460 Oulunsalo (FI)
(72) Inventor: HEIKKINEN, Mikko, FI-90580 Oulu (FI); NISKALA, Paavo, FI-90650 Oulu (FI); RAAPPANA, Pasi, FI-90450 Kempele (FI); SIPPARI, Mikko, FI-90460 Oulunsalo (FI); TORVINEN, Jarkko, FI-90440 Kempele (FI)
(74) Representative: Berggren Oy, Helsinki & Oulu
(86) International application number: PCT/FI2015/050094
(87) International publication number: WO 2015/132455

(56) References cited:
- WO-A1-2005/112526
- JP-A- H10 173 305
- US-A1- 2008 257 706
- US-A1- 2012 314 348
- LI YI ET AL.: 'An all-inkjet printed flexible capacitor for wearable applications' SYMPOSIUM ON DESIGN, TEST, INTEGRATION AND PACKAGING OF MEMS/MOEMS (DTIP 25 April 2012, CANNES, FRANCE, pages 192 - 195, XP032199395
- RAMMAL, R. ET AL.: 'Multimaterial Inkjet Technology for the Fabrication of Microwave Components' PROCEEDINGS OF THE 43RD EUROPEAN MICROWAVE CONFERENCE 07 October 2013, NUREMBERG, GERMANY, pages 790 - 793, XP032535480
- TRAILLE, ANYA ET AL.: 'Monolithic Paper-Based & Inkjet-Printed Technology for Conformal Stepped-FMCW GPR Applications' PROCEEDINGS OF THE 43RD EUROPEAN MICROWAVE CONFERENCE 07 October 2013, NUREMBERG, GERMANY, pages 13 - 16, XP032535500
- PUTAALA, JUSSI ET AL.: 'Reliability of SMD interconnections on flexible low-temperature substrates with inkjet-printed conductors' MICROELECTRONICS RELIABILITY vol. 54, no. 1, January 2014, pages 272 - 280, XP028807539

## Description

### FIELD OF THE INVENTION

Generally the present invention concerns manufacturing processes in the context of electronic products. Particularly, however not exclusively, the invention pertains to manufacturing processes involving printed electronics and the usage of conductive inks.

### BACKGROUND

Miniaturization is a prevalent trend in the manufacturing of electronic products. Additionally, manufacturing costs should be kept minimum, which implies relatively straightforward, high yield processes with reduced number of process stages and material waste among other factors.

Although more traditional electronic elements such as PCBs (printed circuit board), conductors, components like SMDs (surface-mount device), etc. have reduced in size, many of them are still relatively bulky compared to printed electronics. Printed electronics have generally shown the way to thin, light, flexible and rapidly manufactured structures but a vast amount of components cannot still be manufactured by printing, not at least economically and reliably enough.

Accordingly, in many occasions it may sensible to combine several manufacturing technologies to obtain products with desired characteristics, yield and cost.

A standard way of mounting components such as SMDs on a substrate involves disposing electrically conductive solder paste through a stencil onto the substrate to form a number of small pads whereto the components are positioned when the pads are still wet. A reflow oven may be used to effectuate the attachment. Mechanical or physical connection between the substrate and components thereon may be secured by means of adhesives. Alternatively, instead of solder, conductive epoxy adhesives may be utilized to provide both electrical and physical bond between the substrate and the components.

However, solder paste and conductive adhesive based solutions have turned out problematic in some use scenarios.

With particular reference to solder, it has been noticed that certain temperature-sensitive substrate or component materials such as various plastics may not sufficiently withstand the elevated temperatures required by the usage of solder paste, and will thus deteriorate. Yet, solder-applying manufacturing processes tend to have a multitude of different steps considering e.g. the formation of conductors and solder pads, heating, and mechanical strengthening actions such as the usage of epoxies, which renders the overall manufacturing chain rather complicated, time-consuming and costly.

Meanwhile, electrically conductive adhesives have been found too aggressive, propagating too deep into the adjacent materials due to e.g. capillary action. For example, in connection with thin, potentially transparent or translucent, materials the widely spread, clearly visible traces of adhesive, the coverage or distribution of which is rather hard to predict beforehand, may basically spoil the end product aesthetics and also related optical or electrical functionality. Yet, conductive adhesives such as hardened epoxies may after curing be too hard and brittle, not tolerating substantially any flexing or bending and therefore fracturing very easily in applications where they are subjected to that kind of stress, considering e.g. flexible electronics and associated use cases. Further, even the electrical conductivity of such adhesives is often relatively modest, whereupon they best fit low current, low efficiency applications only.

Publication US 2012/0314348 A1 presents an injection molded control panel with in-molded decorated plastic film. Presented are systems and methods for a control assembly including: a first film that is in-molded that includes decorative graphics, a front surface and a rear surface; and a second film molded to the rear surface of the first film having a printed circuit that includes sensors, control circuits and interconnects and a front and rear surface.

Publication WO 2005/112526 A1 presents a printed wiring board, manufacturing method and electronic device. The printed wiring board comprises an insulating layer and a circuit pattern arranged on at least one surface of the insulating layer and made of a conductive material. At least one surface of the insulating layer is provided with a support pattern, which comprises material lines arranged at a distance from each other.

Publication US 2008/0257706 A1 presents an in-molded capacitive switch. A conductive ink sensing zone is printed on a film. The film is formed to a desired shape and put in an injection mold. A molten plastic material is introduced into the injection mold to form a rigid structure that retains the film.

Publication Traille, Anya et al., "Monolithic Paper-Based & Inkjet-Printed Technology for Conformal Stepped-FMCW GPR Applications", Proceeding of the 43rd European Microwave Conference, 7-10 October 2013, pages 13-16, Nuremberg, Germany, presents the design of a monolithic FMCW Ground Penetrating Radar system integrated onto an inkjet-printed patterned flexible substrate.

### SUMMARY OF THE INVENTION

The objective of the embodiments of the present invention is to at least alleviate one or more of the aforesaid drawbacks evident in the prior art arrangements in the context of manufacturing of electronic products incorporating flexible substrates, conductors and various electronic components.

The objective is generally achieved with a method of manufacturing an electronic product as defined in claim 1 and a manufacturing arrangement as defined in claim 12.

In accordance with one aspect of the present invention a method for manufacturing an electronic product, comprises:
- providing a flexible, optionally optically substantially transparent or translucent, substrate film, optionally a flat substrate film,
- printing a number of conductive traces of conductive ink on the substrate film, optionally through screen printing or ink jetting, said traces defining a number of conductors and conductive contact areas, or 'contact pads', for the contacts, such as leads, pins or pads, of at least one electronic surface-mountable component,
- providing substantially non-conductive adhesive to electronic component attachment locations on the substrate film prior to mounting thereon the at least one electronic surface-mountable component,
- after providing the substantially non-conductive adhesive on the substrate film, disposing the at least one electronic surface-mountable component, such as an integrated circuit, on the substrate film such that contacts meet the predefined contact areas when they are still wet to establish the electrical connection between the traces and the at least one component, and to retain the at least one electronic surface-mountable component at least temporarily in place, and
- after disposing the at least one electronic surface-mountable component on the substrate film, 3d-shaping, through thermoforming, the substrate film comprising the conductors, the conductive contact areas, and the at least one component thereon, and
- further securing the physical connection between said at least one component and the substrate, wherein said at least one component is overmoulded so as to at least partly encapsulate it in the molded material, the molded material being plastics, to protect and further secure the component, wherein the substantially non-conductive adhesive is provided to secure the at least one component mechanically to the substrate film.

Overmoulding may be utilized so as to at least partly encapsulate the disposed at least one electronic component in the molded material, preferably plastics, to protect and further secure it. In one embodiment, overmoulding incorporates injection moulding. The substrate containing the traces and components may be utilized as an insert therein.

Substantially non-conductive adhesive such as surface mount glue may be applied to secure the at least one component physically to the substrate.

Further, glop-topping or generally different suitable packaging technologies such as coatings or potting could be selectively exploited to protect and/or secure the components.

In another embodiment, the electrical and/or physical bond between the substrate and the component is secured by means of drying, heating and/or curing using e.g. an oven suitable for the purpose, such as a reflow oven.

In a further embodiment, a plurality of conductive inks is utilized. For instance, one or more inks may be utilized for printing all or selected conductors whereas one or more other inks may be utilized for printing at least some of the conductive mount locations (contact areas).

Naturally, a plurality of electronic surface-mountable components may be provided to the substrate as described hereinbefore, not just one. For each such component, the contact pad and conductor areas may be formed on the substrate by the conductive ink. Still, the substrate may optionally comprise a number of electronic and/or other elements electrically/mechanically secured thereto using other means such as clips, anchors, screws, etc.

In another aspect, a manufacturing arrangement for an electronic product or device, comprises
- printing equipment, optionally screen printing or ink jetting apparatus, to print a number of conductive traces of conductive ink on a flexible, optionally optically substantially transparent or translucent, substrate, said traces defining a number of conductors and conductive contact areas for the contacts of at least one electronic surface-mountable component,
- equipment configured to provide substantially non-conductive adhesive to electronic component attachment locations on the substrate prior to mounting thereon the at least one electronic surface-mountable component,
- mounting equipment, optionally pick and place machine, to place and align the at least one electronic surface-mountable component, such as an integrated circuit, on the substrate so that the contacts meet the predefined contact areas when they are still wet to establish the electrical and physical connection therebetween to retain the at least one electronic surface-mountable component at least temporarily in place, and
- thermoforming equipment configured to 3d-shape the substrate already comprising the conductors, contact areas, and said at least one component,
- securing equipment, being an injection moulding machine and/or, optionally, glue dispensing apparatus, configured to overmold at least part of the substrate film and the at least one component thereon to at least partially encapsulate the at least one component in the molded material, the molded material being plastic to protect and further secure the at least one component.

For example, the disposed electronic component may be overmoulded so as to at least partly encapsulate it in the molded material, preferably plastics.

Yet, the arrangement may comprise a number of additional elements such as drying/heating/curing equipment, cutter, etc.

One or more elements of the arrangement may be optionally integrated together. For example, printing equipment or mounting equipment may also be configured to provide the adhesive such as surface mount adhesive to the substrate. In extreme case, the arrangement is implemented by equipment that could be considered as a single apparatus.

An electronic device manufactured by the method comprises a flexible substrate provided with printed conductive traces defining a number of conductors and contact areas thereon, at least one electronic surface-mountable component placed onto the contact areas so as to electrically connect therewith, said component being further physically secured to the substrate by means of e.g. moulded plastic encapsulation layer covering the component and at least part of the substrate and/or by means of adhesive.

The utility of the embodiments of the present invention results from a variety of different issues. The suggested method involves a reduced number of manufacturing steps relative to many prior art alternatives due to the use of conductive ink for establishing both conductor traces and contact pads for the components, thus yielding simple, short and cost-efficient overall process. The conductive ink, which is preferably substantially nonadhesive, tolerates stretching, bending, shaking, etc. better than at least most of the conductive adhesives, and has better conductivity as well.

The substrate and other elements are also typically subjected to lower thermal stress than in conjunction with solder-based arrangements, which preserves their advantageous properties and reduces heat-generated artifacts.

As a result, flexible, three-dimensional (e.g. bent/arced), durable, light and/or thin electronic/plastic products may be manufactured for various uses. Combining surface mount components with bend films becomes feasible, for instance. The obtained structures will find use in consumer electronics, mobile devices such as tablets or smartphones, automotive industry, user interfaces, sensors, embedded electronics, wearable electronics, optics, etc.

Potentially rather considerable physical fixing characteristics provided by some conventional conductive adhesives are not required in the context of the present invention as fully satisfactory physical attachment may be obtained by utilizing e.g. the combination of traditional non-conductive adhesive, such as epoxy, and e.g. molded plastics to secure the component, such as package or body, to the substrate. Also the (wet) ink may be selected so as to facilitate retaining the component(s) in place at least temporarily prior to subsequent process steps such as heating and/or moulding steps.

The obtained optical quality of the manufactured device or generally product is high as deteriorations caused by aggressive, penetrative and often colored, conductive adhesives are omitted through use of more passive conductive ink(s) and potential non-conductive, merely physical/mechanical bond -providing adhesives. Formation of internal artifacts, such as air/gas pockets or 'bubbles', within the materials such as the moulded plastic commonly caused by conductive adhesives may be avoided or at least reduced.

The expression "a number of" may herein refer to any positive integer starting from one (1).

The expression "a plurality of' may refer to any positive integer starting from two (2), respectively.

Different embodiments of the present invention are also disclosed in the attached dependent claims.

### BRIEF DESCRIPTION OF THE RELATED DRAWINGS

Next, the embodiments of the present invention are more closely reviewed with reference to the attached drawings, wherein
Fig. 1 is a flow diagram disclosing an embodiment of a method in accordance with the present invention.
Fig. 2 illustrates the overall concept of the present invention via an embodiment thereof.

### DETAILED DESCRIPTION

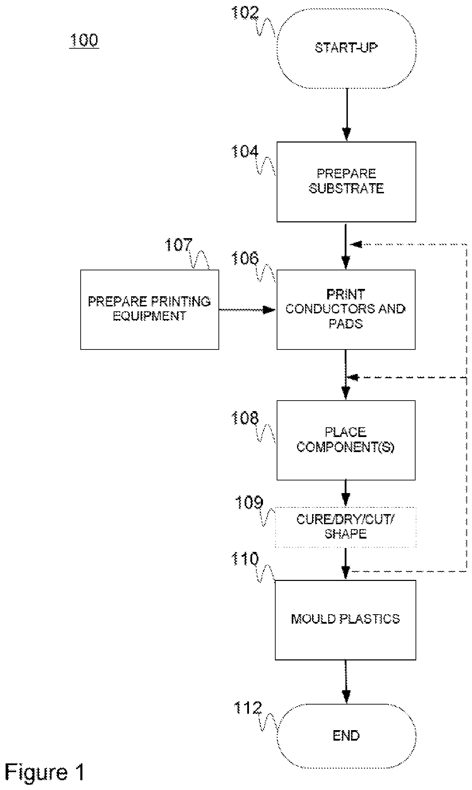

With reference to Figure 1, a flow diagram of one feasible embodiment for manufacturing an electronic product, or device, in accordance with the present invention is shown.

At 102, referring to a start-up phase, the necessary preparatory actions such as material, element and tools general selection, acquisition and preprocessing take place. Circuit layout may be defined in the light of product specification and other constraints. Process parameters may be tested, tweaked and optimized.

Conductive ink(s) is/are acquired. Examples of commonly available conductive inks include e.g. DuPont 5000 ™ and Asahi SW1600C™.

Advantageously, the selected inks are passive in contrast to e.g. many conductive adhesives, and bear rheological properties, e.g. viscosity or surface tension, which enable sufficient flow during ejection or squeezing, i.e. ink dispensing/printing, but prevent the ink from spreading too easily into adjacent materials and structures afterwards. Yet, drying characteristics may be optimized. The preferred sheet resistivity of the printed ink may be about 80 mOhm/sq (at about 10 um thickness) or less, for example, more advantageously about 50 mOhm/sq or less.

Preferably, the conductive ink is selected such that it withstands the necessary amount of strain like stretching so that the traces produced retain their conductivity and potential other desirable properties under stress. The substrate may be subjected to stress during the manufacturing process of the electronic product (considering e.g. shaping) or later during the use thereof.

The conductive ink may contain conductive particles such as nanoparticles. The particles may be metal particles such as metal nanoparticles, but alternatively or additionally, conductive polymer ink may be utilized.

The inks may include silver, gold, copper or carbon as a conductive material, for example. Transparent ink may be used in applications wherein e.g. the material moulded over the substrate/component(s) is transparent or translucent and the underlying conductive traces should not be clearly visible.

As a further example, PTF such as silver-based PTF (Polymer Thick Film) paste type ink could be utilized for (screen) printing the desired circuit design on the film. Also e.g. copper or carbon-based PTF pastes could be used.

Adhesive properties are not needed from the ink, and in most cases, not even desired as they typically introduce problems in terms of durability and controllability as already reviewed hereinbefore.

The physical or mechanical bond between the substrate/traces and electronic components is preferably secured by surface mount adhesive designed or at least suitable for the purpose and/or overmoulding the components using suitable plastic material, for example. The adhesive may be non-conductive as electrical connections are at least preferably established by the conductive ink.

In determining applicable elements and other components/electronics for the method, specific care must be taken that the individual components and material selections work together and survive the selected manufacturing process, which shall be naturally preferably checked up-front on the basis of the manufacturing process vs. element data sheets, or by analyzing the produced prototypes, for example.

At 104, substrate such as a flexible and/or flat substrate film, or alternatively a rigid substrate or a multi-layer/film substrate, is obtained and optionally pre-treated such as coated or otherwise (surface-)processed to elevate its adhesion properties and/or for other purposes. Further, also initial shaping and/or cutting operations may be executed at this point.

The substrate film may comprise e.g. polycarbonate (PC) or polyethylene terephthalate (PET) bearing rather suitable characteristics, such as thermoforming properties and flexibility, in the light of e.g. three-dimensional forming.

Thickness of the substrate may vary according to properties required from the film, such as material strength, flexibility, elasticity, transparency and/or size required from the final product. The thickness of the substrate may be selected depending on the embodiment. It may be a tenth or few tenths of a millimeter only, or more, several millimeters, for example.

The substrate/substrate film may contain a number of structures such as recesses, cavities, or holes, for accommodating elements, which may inelude electronic components, electronic circuits, conductors, component leads, sockets, etc.

At 106, conductive traces of conductive ink are printed onto the substrate, typically according to a predetermined schema. The traces define conductor areas and component contact areas, or 'pads', which may optionally differ from each other in terms of ink constitution, ink layer thickness, dimensions, etc. It shall be noted, however, that the predefined (schema-following) contact areas do not have to necessarily differ from the conductor areas, regarding e.g. shape or used ink, and these two may appear substantially the same, i.e. uniform or homogenous, at least locally on the substrate.

Item 107 refers to the preparation of printing equipment. For instance, in connection with screen printing, first a number of film positives may be created in accordance with the desired circuit layout to be manufactured. Then the screen(s) are provided with the film image(s) using suitable exposure procedure etc., after which the hardened screen(s) are provided to the printing machine or 'press'.

Generally, feasible techniques for printing conductive traces or e.g. graphics include screen-printing, rotary screen printing, gravure printing, flexography, ink-jetting, tampo printing, etc. In some embodiments, multiple printing technologies may be selectively utilized.

The ink(s) shall be preferably selected in connection with the available printing technique and the film material because different printing techniques require different rheological properties from the used ink, for instance. Further, different printing technologies provide varying amounts of ink per time unit, which often affects the achievable conductivity figures.

Alternatively, the conductors and/or graphics may be at least partially provided within the film or overall substrate structure. In some embodiments, the aforementioned PTF technology may be utilized to construct multi-layer solutions with multiple, potentially printed, substrate layers of printed electronics stacked together to form multi-layer, aggregate substrates at least locally on an initial substrate.

At 108, a number of electronic components such as surface-mountable ICs (integrated circuit) and/or other components, e.g. optoelectronics like light-emitting diodes, are placed onto the substrate. A disposed component may generally be active or passive. The various components to be provided on the substrate may be generally based on surface-mount technology. Additionally, other technologies such as printing technologies could be applied. Also hybrid components are feasible, considering e.g. flip chips that are surface mounted.

The components including the contacts thereof are located such that they electrically couple to the predefined contact (pad) areas on the substrate provided by the conductive ink. Additionally, physical binding between the substrate and the component may be strengthened or accomplished through the use of the adhesive. The adhesive may be single-part surface mount epoxy, for instance. Alternatively or additionally, multi-component adhesive may be utilized. The adhesive is preferably non-conductive as discussed hereinbefore.

In some embodiments, a number of additional process phases may next take place. At 109, ink and optional adhesive may be dried, heated and/or cured. The substrate may be cut or otherwise re-dimensioned for the subsequent processing.

Indeed, more complex shaping may take place as optionally in some embodiments, a film type substrate may be processed from substantially flat into substantially three-dimensional. This may be effectuated, for instance, by thermoforming, particularly through vacuum forming or pressure forming, for example. Thermoforming as a process may include heating the film to enter the thermoforming window (i.e. in which the material becomes substantially pliable for stretching and shaping), placing the film into a mold, applying vacuum in order to press the film against the mold so that the film mold to the shape of the mold, letting the film cool down while at the same time applying the vacuum and ejecting the cooled down film, which has now adapted the desired shape according to the mold, by releasing the vacuum and/or applying e.g. air ejection for easier removal of the film. Cutting of the film e.g. to a preferred size may be carried out before or after the thermoforming. The heating of the film into the thermoforming window may be optionally performed inside a thermoforming machine e.g. in the mold, or outside the thermoforming machine e.g. in an oven.

Considering the parameters and set-up of the preferred thermoforming process using vacuum or pressure, few further guidelines can be given as mere examples as being understood by the persons skilled in the art. Few approximate examples for the lower limit of the thermoforming temperature include: PC 150°C, PET 70°C, ABS 88°C-120°C. The pressure applied on the film obtained either by pressing mechanically air into the mold or by sucking a vacuum into the mold could be roughly over some 100psi for a single layer film construction and roughly over some 200psi for laminated structures. The used three-dimensional film and the process parameters shall be preferably selected such that the film does not melt or the components separate therefrom.

At 110, the assembly comprising the components attached to the substrate may be placed, depending on the embodiment, as an insert into a mold frame and overmolded by injection molding, for example. The material molded over the substrate is optionally transparent and may comprise polymers such as polycarbonate (PC), polyethylene terephthalate (PET), polymethyl methacrylate (PMMA), polyamide (PA), cyclo olefin copolymer (COC), cyclo olefin polymer (COP), polytetrafluoroethylene (PTFE), polyvinyl chloride (PVC), or a mixture of these. Alternatively or additionally, the material could include e.g. glass. An applicable layer material shall be generally selected such that the desired flexibility, robustness, and other requirements like adhesion and/or optical properties in view of the electronics and the adjacent materials, or e.g. in view of available manufacturing techniques and target use, are met.

Having regard to the process parameters and set-up, few further guidelines could be given as mere examples as being understood by the skilled persons. When the three-dimensional film is PET and the plastics to be, for example, injection molded thereon is PC, the temperature of the melted PC may be about 280 to 320°C and mold temperature about 20 to 95°C, e.g. about 80°C. The used three-dimensional film, electronic components and process parameters shall be preferably selected such that the film/components remain substantially static and unharmed during the process. After the injection process the injected material may be kept under a pressure and let to cool down, after which it may be taken out.

By molding, the desired components and substrate portions may be generally encapsulated and the substrate covered to a desired extent by the molding material, which may thus form protective shell, cover or housing of the manufactured device.

Yet, the molding material may be configured to establish other functional elements such as transmission medium for light/electromagnetic radiation in case the components include e.g. optoelectronic elements such as lightemissive or -sensitive elements. In-mold labelling or decoration may further be used to exhibit desired, embedded visual appearance to the users of the product.

At 112, the method execution is ended. Further actions such as element regulation, quality control, surface treatment and/or finishing or furbishing may take place next. The dashed loop-back arrows depict the potentially repetitive nature of method items, wherein printing, component placing and/or other activities may occur in phases.

The use of advantageously flexible materials enables at least some of the method items to be carried out by roll-to-roll or 'reel-to-reel' methods, which may provide additional benefits time-, cost- and even space-wise considering e.g. transportation and storage.

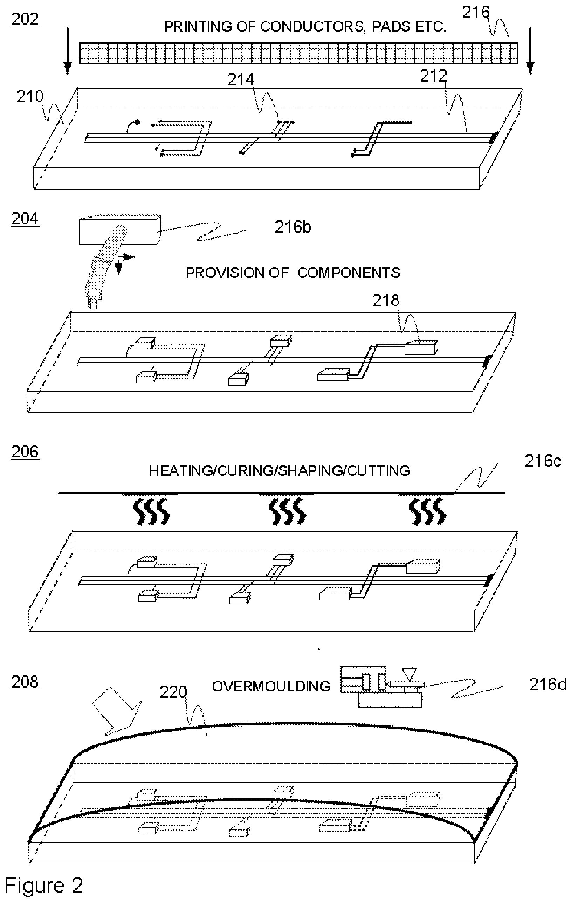

Accordingly, Fig. 2 illustrates the concept of the present invention by few simplistic sketches in relation to the potential corresponding method steps.

At 202, a substrate 210, such as a flat, thin and/or flexible substrate film, optionally of plastic material, is provided with printed conductive (ink) traces defining a plurality of conductors 212 and contact areas 214 (which may have different shapes and may be, but do not have to be, visually distinguishable from conductor traces), or 'pads', for electronic components such as surface mountable ICs or other surface mountable elements. Contact areas 214 may define optionally larger diameter extensions for the conductors 212, which is the case shown in the figure, or connect different elongated conductor portions together, for example.

Additionally, printable electronic components, e.g. printable OLED (organic LED), may be constructed onto the substrate.

As item 216 alludes, screen/screen printing may be applied for producing the traces among other options such as ink-jetting, already listed hereinbefore. Yet, adhesive(s) for mechanical fixing may be provided onto the substrate, optionally also by printing.

At 204, the substrate 210 receives the electronic components 218 such as various surface mountable components. Mounting including aligning to the printed contact areas may be executed using suitable placement technology 216b for the purpose, e.g. a suitable pick and place machine or bonder.

Adhesive(s) for securing mechanical attachments of components may be provided by the same or dedicated equipment, e.g. a glue dispenser, prior to placing the electronic components, optionally with the components. Drops of adhesive may be provided on the substrate to the locations of the electronic components 218 prior to mounting those, for instance. Adhesive(s) may also be printed as mentioned above.

In addition to electronic components, in connection with the present invention also other elements could be located onto the substrate or within the molded material considering e.g. various embodiments of in-mould labelling/decoration.

At 206, it is indicated that the substrate and components may be subjected to various treatments. The substrate may be heated/dried/cured by suitable equipment 216c to dry the ink, strengthen the mechanical bond/cure the adhesive, etc. Alternatively or additionally, remainder substrate may be cut away, desired shaping (e.g. 3D) may take place, etc.

At 208, the substrate is shown with a layer or element 220 of preferably plastic material overmoulded thereon using e.g. injection moulding through the utilization of applicable hardware 216d, wherein the substrate could have been applied as an insert, to further secure the attachment of components, enhance protection to external conditions such as hermetic isolation, shock and impact protection, exhibit desired optical properties and geometry (dimensions), etc.

The shown arched shape of moulded cover 220 is merely exemplary, but such curved shapes, or alternatively edgy shapes, may indeed generally be obtained for the moulded element 220 depending on the target design. Recalling the fact that the substrate 210 may itself be non-flat or three dimensional (shaping may take place prior to moulding as described hereinbefore), also the manufactured overall product may bear even rather complex 3d-shape, not just the moulded element 220.

The scope of the invention is determined by the attached claims. The skilled persons will again appreciate the fact that the disclosed embodiments were constructed for illustrative purposes only, and further embodiments, embodiment combinations, variations are possible that better suit each particular use case of the invention.

## Claims

1. A method (100) for manufacturing an electronic product, comprising:
- providing (104) a flexible substrate film,
- printing (106, 107) a number of conductive traces of conductive ink on the substrate film, said traces defining a number of conductors and conductive contact areas for the contacts of at least one electronic surface-mountable component,
- providing substantially non-conductive adhesive to electronic component attachment locations on the substrate film prior to mounting thereon the at least one electronic surface-mountable component; **characterized by**
- after providing the substantially non-conductive adhesive on the substrate film, disposing (108) the at least one electronic surface-mountable component on the substrate film so that the contacts meet the predefined contact areas when they are still wet to establish the electrical connection therebetween and to retain the at least one electronic surface-mountable component at least temporarily in place,
- after disposing the at least one electronic surface-mountable component on the substrate film, 3d-shaping (109), through thermoforming, the substrate film comprising the conductors, the conductive contact areas, and the at least one component thereon, and
- further securing (110) the physical connection between said at least one component and the substrate, wherein said at least one component is overmoulded so as to at least partly encapsulate it in the molded material, the molded material being plastics, to protect and further secure the component, wherein the substantially non-conductive adhesive is provided to secure the at least one component mechanically to the substrate film.

2. The method of any preceding claim, wherein the ink is passive and non-aggressive in terms of penetration capability to a predetermined adjacent material, optionally molded material.

3. The method of any preceding claim, wherein the sheet resistivity of the ink is equal or lower than about 80 mOhm/sq at about 10 um print thickness.

4. The method of any preceding claim, wherein the ink and/or said at least one component is dried, heated, and/or cured after positioning the at least one component upon the substrate film.

5. The method of any preceding claim, wherein the substrate film is cut after positioning the at least one component.

6. The method of any preceding claim, wherein the substrate film comprises or is substantially made from at least one material selected from the group consisting of: silicon, rubber, polyethylene terephthalate (PET), polycarbonate (PC), acrylonitrile-butadiene-styrene (ABS), polymethyl methacrylate (PMMA), Glycolized polyethylene terephthalate (PETG), high impact polystyrene (HIPS), high-density polyethylene (HDPE), and acrylic polymer.

7. The method of any preceding claim, wherein the thickness of the substrate is in the order of magnitude of tenths of a millimeter or less.

8. The method of any preceding claim, wherein said printing is implemented utilizing at least one printing technique selected from the group consisting of: screen printing, rotary screen printing, gravure printing, flexography, ink jetting, tampo printing, transfer-lamination, and thin-film deposition.

9. The method of any preceding claim, wherein said at least one component comprises a flip chip.

10. The method of any preceding claim, wherein in-mold labelling or decoration is utilized to produce a visible and visually distinguishable feature underneath the outer surface of a material moulded over the substrate.

11. The method of any preceding claim, wherein material is molded over the substrate film, said material optionally being optically substantially transparent or translucent material, said material comprising at least one material selected from the group consisting of: polycarbonate (PC), polyethylene terephthalate (PET), polymethyl methacrylate (PMMA), polyamide (PA), cyclo olefin copolymer (COC), cyclo olefin polymer (COP), polytetrafluoroethylene (PTFE), and polyvinyl chloride (PVC).

12. A manufacturing arrangement for an electronic product, comprising
- printing equipment (210) configured to print a number of conductive traces of conductive ink on a flexible substrate, said traces defining a number of conductors and conductive contact areas for the contacts of at least one electronic surface-mountable component,
- equipment configured to provide substantially non-conductive adhesive to electronic component attachment locations on the substrate prior to mounting thereon the at least one electronic surface-mountable component, **characterized by**
- mounting equipment (216b) configured to place and align the at least one electronic surface-mountable component on the substrate so that the contacts meet the pre-defined contact areas when they are still wet to establish the electrical and physical connection therebetween and to retain the at least one electronic surface-mountable component at least temporarily in place,
- thermoforming equipment (216c) configured to 3d-shape the substrate already comprising the conductors, contact areas, and said at least one component, and
- securing equipment (216d), being an injection moulding machine, configured to overmold at least part of the substrate film and the at least one component thereon to at least partially encapsulate the at least one component in the molded material, the molded material being plastic to protect and further secure the at least one component.

## Patentansprüche

1. Verfahren (100) zum Herstellen eines elektronischen Produkts, umfassend:
- Bereitstellen eines flexiblen Substratfilms (104),
- Drucken (106, 107) einer Anzahl von leitenden Spuren von leitender Tinte auf den Substratfilm,
wobei die Spuren eine Anzahl von Leitern und leitenden Kontaktflächen für die Kontakte mindestens einer elektronischen oberflächenmontierbaren Komponente definieren,
- Bereitstellen eines im Wesentlichen nicht leitenden Klebstoffs an Befestigungsstellen elektronischer Komponenten auf dem Substratfilm vor der Montage der mindestens einen elektronischen oberflächenmontierbaren Komponente darauf; **gekennzeichnet durch**
- nach dem Bereitstellen des im Wesentlichen nicht leitenden Klebstoffs auf den Substratfilm, Anordnen (108) der mindestens einen elektronischen oberflächenmontierbaren Komponente auf dem Substratfilm, so dass die Kontakte die vordefinierten Kontaktflächen treffen, wenn sie noch feucht sind, um die elektrische Verbindung zwischen ihnen herzustellen und die mindestens eine elektronische oberflächenmontierbare Komponente zumindest vorübergehend an Ort und Stelle zu halten,
- nach dem Anordnen der mindestens einen elektronischen oberflächenmontierbaren Komponente auf dem Substratfilm, 3d-Formen (109) durch Thermoformen des Substratfilms, der die Leiter, die leitenden Kontaktflächen und die mindestens eine Komponente darauf umfasst, und
- weiteres Sichern (110) der physikalischen Verbindung zwischen der mindestens einen Komponente und dem Substrat, wobei die mindestens eine Komponente überformt ist, um sie zumindest teilweise in das geformtes Material einzukapseln, wobei das geformte Material Kunststoff ist, um die Komponente zu schützen und weiter zu sichern, wobei der im Wesentlichen nicht leitende Klebstoff vorgesehen ist, um die mindestens eine Komponente mechanisch an dem Substratfilm zu befestigen.

2. Verfahren nach einem der vorhergehenden Ansprüche, wobei die Tinte passiv und nicht aggressiv in Bezug auf die Durchdringungsfähigkeit in ein vorbestimmtes benachbartes Material, gegebenenfalls geformtes Material, ist.

3. Verfahren nach einem der vorhergehenden Ansprüche, wobei der spezifische Schichtwiderstand der Tinte bei etwa 10 um Druckdicke gleich oder niedriger als etwa 80 mOhm/sq ist.

4. Verfahren nach einem der vorhergehenden Ansprüche, wobei die Tinte und/oder die mindestens eine Komponente getrocknet, erhitzt und/oder gehärtet werden, nachdem die mindestens eine Komponente auf dem Substratfilm positioniert wurde.

5. Verfahren nach einem der vorhergehenden Ansprüche, wobei der Substratfilm nach dem Positionieren der mindestens einen Komponente geschnitten wird.

6. Verfahren nach einem der vorhergehenden Ansprüche, wobei der Substratfilm mindestens ein Material umfasst oder im Wesentlichen aus diesem hergestellt ist, ausgewählt aus der Gruppe bestehend aus: Silizium, Kautschuk, Polyethylenterephthalat (PET), Polycarbonat (PC), Acrylnitril-Butadien-Styrol (ABS), Polymethylmethacrylat (PMMA), glykolisiertes Polyethylenterephthalat (PETG), schlagfestes Polystyrol (HIPS), Polyethylen hoher Dichte (HDPE) und Acrylpolymer.

7. Verfahren nach einem der vorhergehenden Ansprüche, wobei die Dicke des Substrats in der Größenordnung von Zehntel Millimetern oder weniger liegt.

8. Verfahren nach einem der vorhergehenden Ansprüche, wobei das Drucken unter Verwendung mindestens einer Drucktechnik implementiert ist, ausgewählt aus der Gruppe bestehend aus: Siebdruck, Rotationssiebdruck, Tiefdruck, Flexodruck, Tintenstrahl, Tampondruck, Transferlaminierung und Dünnschichtabscheidung.

9. Verfahren nach einem der vorhergehenden Ansprüche, wobei die mindestens eine Komponente einen Flip-Chip umfasst.

10. Verfahren nach einem der vorhergehenden Ansprüche, wobei Markieren oder Dekorieren in der Form verwendet wird, um ein sichtbares und visuell unterscheidbares Merkmal unter der Außenfläche eines über dem Substrat geformten Materials zu erzeugen.

11. Verfahren nach einem der vorhergehenden Ansprüche, wobei Material über den Substratfilm geformt wird, wobei das Material gegebenenfalls optisch im Wesentlichen transparentes oder durchscheinendes Material ist, wobei das Material mindestens ein Material umfasst, ausgewählt aus der Gruppe bestehend aus: Polycarbonat (PC), Polyethylenterephthalat (PET), Polymethylmethacrylat (PMMA), Polyamid (PA), Cycloolefincopolymer (COC), Cycloolefinpolymer (COP), Polytetrafluorethylen (PTFE) und Polyvinylchlorid (PVC).

12. Herstellungsanordnung für ein elektronisches Produkt, umfassend
- Druckvorrichtung (210), die konfiguriert ist, um eine Anzahl von leitenden Spuren von leitender Tinte auf ein flexibles Substrat zu drucken, wobei die Spuren eine Anzahl von Leitern und leitenden Kontaktflächen für die Kontakte mindestens einer elektronischen oberflächenmontierbaren Komponente definieren,
- Vorrichtung, die konfiguriert ist, um einen im Wesentlichen nicht leitenden Klebstoff an Befestigungsstellen elektronischer Komponenten auf dem Substratfilm vor der Montage der mindestens einen elektronischen oberflächenmontierbaren Komponente darauf bereitzustellen, **gekennzeichnet durch**
- Montagevorrichtung (216b), die konfiguriert ist, um die mindestens eine elektronische oberflächenmontierbare Komponente auf dem Substrat zu platzieren und auszurichten, so dass die Kontakte die vordefinierten Kontaktflächen treffen, wenn sie noch feucht sind, um die elektrische und physikalische Verbindung zwischen ihnen herzustellen und die mindestens eine elektronische oberflächenmontierbare Komponente zumindest vorübergehend an Ort und Stelle zu halten,
- Thermoformungsvorrichtung (216c), die konfiguriert ist, um das Substrat, das bereits die Leiter, Kontaktflächen und die mindestens eine Komponente umfasst, 3d-förmig zu formen, und
- Vorrichtung zum Sichern (216d), die eine Spritzgussmaschine ist, die konfiguriert ist, um mindestens einen Teil des Substratfilms und die mindestens eine Komponente darauf zu überformen, um die mindestens eine Komponente in dem geformten Material zumindest teilweise einzukapseln, wobei das geformte Material Kunststoff ist, um die mindestens eine Komponente zu schützen und weiter zu sichern.

## Revendications

1. Procédé (100) de fabrication d'un produit électronique, comprenant :
- la fourniture (104) d'un film de substrat flexible,
- l'impression (106, 107) d'un certain nombre de traces conductrices d'encre conductrice sur le film de substrat, lesdites traces définissant un certain nombre de conducteurs et de zones de contact conductrices pour les contacts d'au moins un composant électronique montable en surface,
- la fourniture d'un adhésif sensiblement non conducteur aux emplacements de fixation de composant électronique sur le film de substrat avant de monter sur celui-ci l'au moins un composant électronique montable en surface ; **caractérisé par**
- après la fourniture de l'adhésif sensiblement non conducteur sur le film de substrat, la disposition (108) de l'au moins un composant électronique montable en surface sur le film de substrat de sorte que les contacts rencontrent les zones de contact prédéfinies quand elles sont encore humides pour établir la connexion électrique entre eux et pour maintenir l'au moins un composant électronique montable en surface au moins temporairement en place,
- après la disposition de l'au moins un composant électronique montable en surface sur le film de substrat, la mise en forme 3D (109), par thermoformage, du film de substrat comprenant les conducteurs, les zones de contact conductrices et l'au moins un composant sur celui-ci, et
- la fixation (110) en outre de la connexion physique entre ledit au moins un composant et le substrat, dans lequel ledit au moins un composant est surmoulé de manière à l'encapsuler au moins partiellement dans le matériau moulé, le matériau moulé étant du plastique, pour protéger et en outre fixer le composant, dans lequel l'adhésif sensiblement non conducteur est prévu pour fixer l'au moins un composant mécaniquement au film de substrat.

2. Procédé selon une quelconque revendication précédente, dans lequel l'encre est passive et non agressive en termes de capacité de pénétration dans un matériau adjacent prédéterminé, éventuellement un matériau moulé.

3. Procédé selon une quelconque revendication précédente, dans lequel la résistivité de feuille de l'encre est égale ou inférieure à environ 80 mOhm/carré pour une épaisseur d'impression d'environ 10 um.

4. Procédé selon une quelconque revendication précédente, dans lequel l'encre et/ou ledit au moins un composant est séché, chauffé et/ou durci après le positionnement de l'au moins un composant sur le film de substrat.

5. Procédé selon une quelconque revendication précédente, dans lequel le film de substrat est coupé après le positionnement de l'au moins un composant.

6. Procédé selon une quelconque revendication précédente, dans lequel le film de substrat comprend ou est sensiblement constitué d'au moins un matériau choisi dans le groupe constitué de : silicium, caoutchouc, polyéthylène téréphtalate (PET), polycarbonate (PC), acrylonitrile-butadiène-styrène (ABS), polyméthacrylate de méthyle (PMMA), polyéthylène téréphtalate glycolisé (PETG), polystyrène à haute résistance aux chocs (HIPS), polyéthylène haute densité (HDPE) et polymère acrylique.

7. Procédé selon une quelconque revendication précédente, dans lequel l'épaisseur du substrat est de l'ordre de grandeur du dixième de millimètre ou moins.

8. Procédé selon une quelconque revendication précédente, dans lequel ladite impression est mise en œuvre en utilisant au moins une technique d'impression choisie dans le groupe constitué de : la sérigraphie, la sérigraphie rotative, l'héliogravure, la flexographie, la projection d'encre, la tampographie, la stratification par transfert et le dépôt de film mince.

9. Procédé selon une quelconque revendication précédente, dans lequel ledit au moins un composant comprend une puce à protubérances.

10. Procédé selon une quelconque revendication précédente, dans lequel l'étiquetage ou la décoration dans le moule est utilisé(e) pour produire une caractéristique visible et visuellement distinguable sous la surface extérieure d'un matériau moulé sur le substrat.

11. Procédé selon une quelconque revendication précédente, dans lequel le matériau est moulé sur le film de substrat, ledit matériau étant éventuellement un matériau optiquement sensiblement transparent ou translucide, ledit matériau comprenant au moins un matériau choisi dans le groupe constitué de : polycarbonate (PC), polyéthylène téréphtalate (PET), polyméthacrylate de méthyle (PMMA), polyamide (PA), copolymère de cyclo-oléfine (COC), polymère de cyclo-oléfine (COP), polytétrafluoroéthylène (PTFE) et chlorure de polyvinyle (PVC).

12. Agencement de fabrication pour un produit électronique, comprenant
- un équipement d'impression (210) configuré pour imprimer un certain nombre de traces conductrices d'encre conductrice sur un substrat flexible, lesdites traces définissant un certain nombre de conducteurs et de zones de contact conductrices pour les contacts d'au moins un composant électronique montable en surface,
- un équipement configuré pour fournir un adhésif sensiblement non conducteur aux emplacements de fixation de composant électronique sur le substrat avant de monter sur celui-ci l'au moins un composant électronique montable en surface, **caractérisé par**
- un équipement de montage (216b) configuré pour placer et aligner l'au moins un composant électronique montable en surface sur le substrat de sorte que les contacts rencontrent les zones de contact prédéfinies lorsqu'elles sont encore humides pour établir la connexion électrique et physique entre eux et pour maintenir l'au moins un composant électronique montable en surface au moins temporairement en place,
- un équipement de thermoformage (216c) configuré pour former en 3D le substrat comprenant déjà les conducteurs, les zones de contact et ledit au moins un composant, et
- un équipement de fixation (216d), qui est une machine de moulage par injection, configuré pour surmouler au moins une partie du film de substrat et l'au moins un composant sur celui-ci pour encapsuler au moins partiellement l'au moins un composant dans le matériau moulé, le matériau moulé étant du plastique pour protéger et en outre fixer l'au moins un composant.
